# EUROPEAN PATENT SPECIFICATION

(11) **EP 1 512 178 B1**
(45) Date of publication and mention of the grant of the patent: **21.09.2011**
(21) Application number: 03728777.8
(22) Date of filing: 12.05.2003
(51) Int. Cl.: H01L 27/02

(54) **SEMICONDUCTOR FILTER CIRCUIT**
HALBLEITERFILTERSCHALTUNG
CIRCUIT DE FILTRAGE A SEMI-CONDUCTEUR

(30) Priority: 11.06.2002 US 166288
(43) Date of publication of application: 09.03.2005
(73) Proprietor: Semiconductor Components Industries, LLC, Phoenix, Arizona 85008 (US)
(72) Inventor: ESCOFFIER, Rene, F-31410 Mauzac (FR); PEARSE, Jeffrey, Chandler, AZ 85224 (US); ROBB, Francine, Y., Fountain Hills, AZ 85268 (US); STEFANOV, Evgueniy, Nikolov, F-31320 Vieille Toulouse (FR); ZDEBEL, Peter, J., Austin, TX 78733 (US)
(74) Representative: Turnbull, Alexander James
(86) International application number: PCT/US2003/014505
(87) International publication number: WO 2003/105228

(56) References cited:
- EP-A- 0 741 413
- WO-A-01/63672
- WO-A-98/56020
- WO-A2-98/56020
- US-A- 4 017 885
- US-A- 4 017 885
- US-A- 6 121 669
- US-A- 6 121 669
- V. PRASAD KODALI: "Engineering Electromagnetic Compatibility", 2001, IEEE PRESS, NEW YORK ISBN: 0-7803-4743-9 * Chapter 10: EMI Filters *
- V. PRASAD KODALI: "Engineering Electromagnetic Compatibility" 2001, IEEE PRESS , NEW YORK ISBN: 0-7803-4743-9 Chapter 10: EMI Filters

## Description

### Background of the Invention

The present invention relates in general to semiconductor devices and, more particularly, to low frequency filter networks formed on semiconductor substrates.

Wireless communications devices typically operate using both radio frequency (RF) signals and lower frequency audio signals. For example, cellular telephones transmit RF carrier signals that operate at frequencies of six gigahertz or more and are modulated with audio frequency voice information. A microphone generates an audio frequency signal from the voice information which is amplified and used to modulate the RF carrier signal. Most wireless communications devices use a low pass filter at the microphone input to suppress ambient RF carrier signals that may be "picked up" or detected by the microphone in order to avoid degrading the performance of the communications device by noisy operation, loop instability, or other effects that reduce the quality of the modulating audio signal. To accomplish this function, the low pass filters have a passband in the audio range, i.e., less than about twenty kilohertz.

Presently, these audio filters are formed with discrete passive components because of the difficulty of forming the large component values that set the filters' low frequency passband. However, the discrete filters add a substantial fabrication cost to a wireless device. Integrated filters based on semiconductor technology have a lower cost but have not been practical because of the large die area needed to integrate audio frequency components while providing an adequate voltage capability.

Hence, there is a need for an integrated filter that provides a high level of frequency selectivity while maintaining a low manufacturing cost.
Prior art document US 6,121,669 (California Micro Devices Corp) discloses a thin film protected capacitor structure comprising back-to-back diodes, for integrated RC or RLC networks.
Prior art document US 4,017,885 (Texas Instruments Inc) discloses a semiconductor capacitor which utilises the volume of the semiconductor substrate in which it is formed to provide increased capacitance.
Prior art document WO 98/56020 (Telefonaktiebolaget LM Ericsson) discloses a buried capacitor for semiconductor circuits.
Text book V. Prasad Kosali, Engineering Electromagnetic Compatibility, 2001, IEEE Press, New York, discloses in Chapter 10 the principles of electromagnetic interference (EMI) filter design.
The above objectives are achieved by an integrated filter according to claim 1.

### Brief Description of the Drawings

FIG. 1 is a block diagram of a wireless communications device related to the invention;
FIG. 2 is a schematic diagram of a filter circuit according to the invention ;
FIG. 3 is a cross-sectional view of the filter circuit integrated on a semiconductor substrate in an embodiment;
FIG. 3A is a top view of the drawing of the filter circuit of FIG. 3 showing an inductor;
FIG. 4 is a cross-sectional view of the filter circuit in an alternative embodiment; and
FIG. 5 is a cross-sectional view of the filter circuit in an example not forming part of the claimed invention.

### Detailed Description of the Drawings

In the figures, elements having the same reference number have similar functionality.

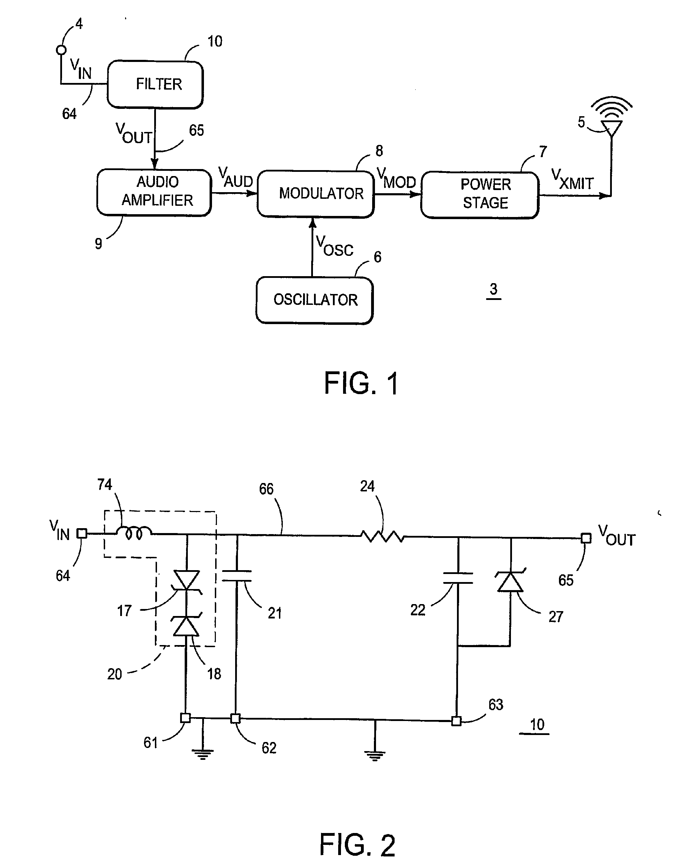

FIG. 1 is a block diagram of a wireless communications device 3, including a microphone 4, an antenna 5, an oscillator 6, a power stage 7, a modulator 8, an audio amplifier 9 and a filter 10. Communications device 3 converts voice information received through microphone 4 to an electrical input signal V_{IN} at a lead 64 of filter 10, and produces an RF transmitter signal V_{KMIT} at a power level of two watts or more for transmitting by antenna 5. In one embodiment, communications device 3 is configured as a cellular telephone that broadcasts transmitter signal V_{KMIT} to, for example, a cellular base station.

Filter 10 is a low pass microphone line filter used to suppress RF components of input signal V_{IN} from other circuitry of communications device 3 such as audio amplifier 9. That is, filter 10 passes the audio frequency components of input signal V_{IN} while rejecting or attenuating RF components. The audio components are generated by microphone 4 from voice information, while the RF components are produced by, for example, incident electromagnetic waves generated by antenna 5 at the V_{XMIT} carrier frequency. In the case of a cellular telephone, where microphone 4 is in close proximity to antenna 5, the RF components, if not attenuated or suppressed, can have an amplitude sufficient to overload audio amplifier 9 or to cause signal distortion, noise, instability, or other undesirable effects on the performance of communications device 3. Filter 10 has an output at a lead 65 for producing a filtered audio output signal V_{OUT}. Filter 10 is specified to pass audio frequency components of V_{IN} while attenuating RF component frequencies by a factor of at least thirty decibels at a frequency of six gigahertz. Hence, V_{OUT} is substantially comprised of audio frequency components with few or no RF components.

Audio amplifier 9 amplifies output signal V_{OUT} and produces an amplified audio signal V_{AUD}. Oscillator 6 generates an RF oscillator signal V_{OSC} at the desired carrier frequency of transmitter signal V_{XMIT}. Modulator 8 modulates V_{OSC} with V_{AUD} and produces a modulated signal V_{MOD} which is coupled to power stage 7 and amplified to produce transmitter signal V_{XMIT}. In one embodiment, V_{XMIT} has an RF carrier frequency of about six gigahertz.

FIG. 2 is a schematic diagram of filter 10, including a resistor 24, capacitors 21-22, a clamp diode 27 and an electrostatic discharge (ESD) device 20 that includes back to back diodes 17-18 and an inductor 74. Input signal V_{IN} has both audio frequency components and undesirable RF components. Output 65 produces filtered output signal V_{OUT} operating at audio frequencies with RF components attenuated or suppressed. Filter 10 is configured for integrating on a semiconductor die to form an integrated circuit.

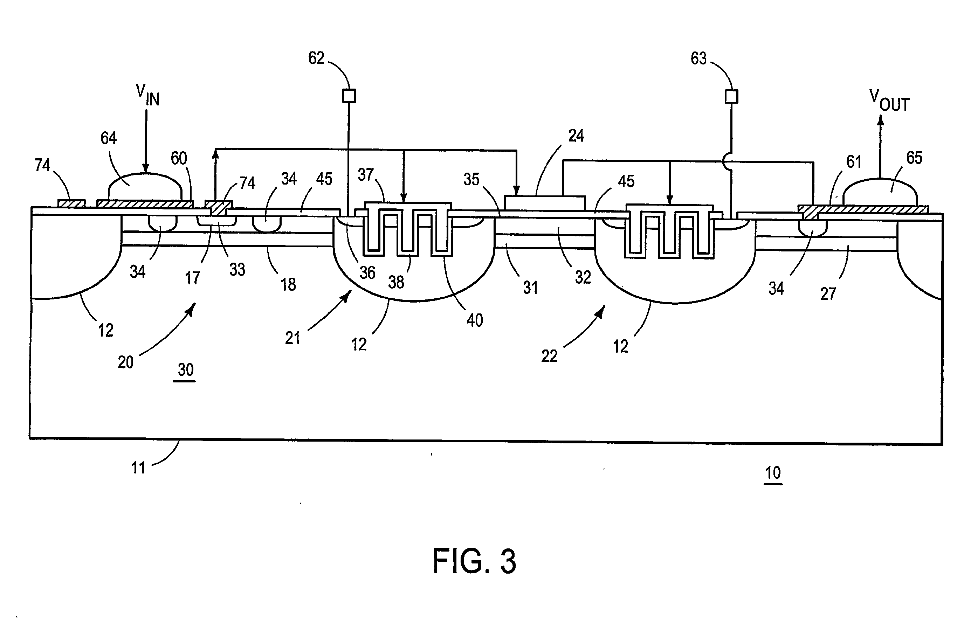

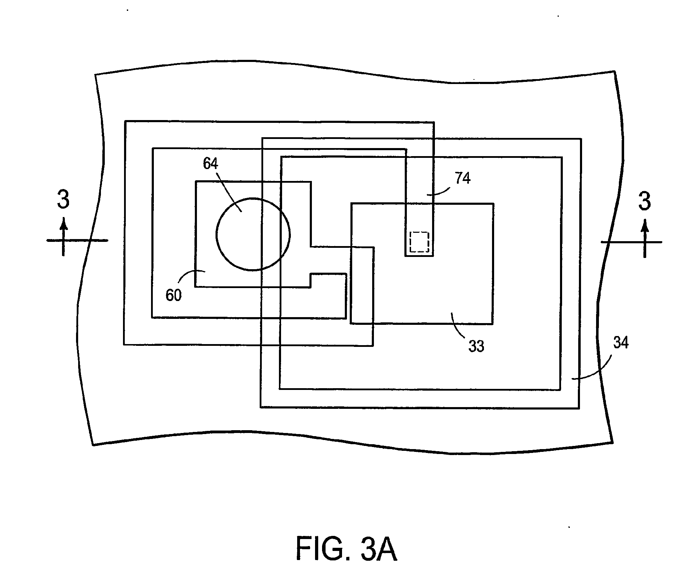

Diodes 17-18 of ESD device 20 comprise back to back zener or avalanche diodes formed as junctions in a semiconductor substrate as described below. Diodes 17-18 are referred to as back to back diodes because their common cathode (or, alternatively, common anode) arrangement results in one of them being reverse biased regardless of the polarity of V_{IN}. ESD device 20 dissipates electrostatic energy in the form of high voltage peaks of short duration which could damage sensitive system components. In one embodiment, ESD device 20 is formed to comply with International Electrotechnical Commission standard IEC61000-4-2 level four. In the embodiment of FIG. 3, diodes 17-18 have their respective cathodes commonly connected as shown to break down symmetrically when the voltage amplitude at node 66 reaches about fourteen volts positive and/or fourteen volts negative. During a positive voltage peak, diode 17 forward biases and diode 18 avalanches at about 13.3 volts, and during a negative voltage peak, diode 18 forward biases and diode 17 avalanches at about 13.3 volts. Alternatively, ESD device 20 may include back to back diodes formed with their anodes commonly connected, rather than their cathodes, to achieve a similar protective function.

Inductor 74 is formed as a planar spiral inductor to have a typical value in a range between 1-5 nanohenries. In one embodiment, inductor 74 is formed by patterning a standard metal interconnect layer.

Capacitors 21-22 are formed as trench capacitors connected as shown to respectively produce capacitances C₂₁=C₂₂=1.0 nanofarads, approximately, that modify the frequency response of V_{IN} to produce filtered output signal V_{OUT}. The trench design provides capacitors 21-22 with a low equivalent series resistance, and therefore a high quality factor, which results in a low impedance and high quality filtering function at RF frequencies.

Resistor 24 is formed as a thin film resistor, typically with a low parasitic substrate capacitance for enhanced filter performance. Resistor 24 cooperates with capacitors 21-22 to establish a characteristic frequency response for filter 10. In one embodiment, resistor 24 is formed with doped polysilicon having a concentration selected to produce the specified resistance value in a small die area while providing a high level of control to maintain the resistances within a specified tolerance. In one embodiment, the value of resistor 24 is controlled to within plus or minus ten percent. In one embodiment, resistor 24 has a resistance of about fifty ohms and a temperature coefficient of resistance approaching zero.

Clamp diode 27 is an avalanche diode that breaks down to limit the voltage swing at lead 65 to avoid overloading the input stage of amplifier 9. Accordingly, clamp diode 27 also provides an ESD protection function at lead 65. In one embodiment, clamp diode 27 is formed with a structure similar to that of either diode 17 or diode 18, and therefore has similar characteristics, i.e., a breakdown voltage of about 13.3 volts.

FIG. 3 shows a cross-sectional view of filter 10 formed on a semiconductor substrate 11 and configured as an integrated filter circuit, showing inductor 74, resistor 24, ESD device 20, clamp diode 27 and capacitors 21-22.

A base layer 30 is formed with semiconductor material and heavily doped to function as a low resistance ground plane for filter 10. In one example, base layer 30 has a doping concentration in a range between 10¹⁶ and 10²¹ atoms/centimeter³. According to the claimed invention, base layer 30 has a doping concentration in a range between 10¹⁸ and 10²¹ atoms/centimeter³. For example, base layer 30 may comprise monocrystalline silicon doped to provide a p-type conductivity and a doping concentration of about 2*10²⁰ atoms/centimeter³. The low resistivity of base layer 30 provides an effective ground plane that attenuates parasitic signals that would otherwise propagate through base layer 30 along parasitic signal paths to produce crosstalk and degrade filter performance.

An epitaxial layer 31 is grown over base layer 30 and doped to have an n-type conductivity. Epitaxial layer 31 forms a junction with base layer 30 to comprise diode 18, so the doping concentration of epitaxial layer 31 is selected to provide a specified avalanche voltage for diode 18 such as, for example, 13.3 volts. Epitaxial layer 31 typically has a thickness in a range between two and ten micrometers. In one embodiment, epitaxial layer 31 is grown to a thickness of about 2.5 micrometers and a concentration of about 5*10¹⁷ atoms/centimeter³.

A layer 32 is formed over epitaxial layer 31 to have an n-type conductivity. A doped region 33 is formed by introducing p-type dopants from a surface 35 of substrate 11 to produce a junction that functions as diode 17. The doping concentrations of epitaxial layer 32 and doped region 33 are selected to provide a specified avalanche voltage for diode 17 such as, for example, 13.3 volts. In one embodiment, layer 32 is an epitaxial layer grown to a thickness of about three micrometers and a concentration of about 1*10¹⁷ atoms/centimeter³, and doped region 33 has a thickness of about one micrometer and a surface, concentration of about 6.0*10¹⁹ atoms/centimeter³. Alternatively, epitaxial layer 31 is grown to a thickness of about 5.5 micrometers and layer 32 is formed.by subjecting epitaxial layer 31 to a blanket p-type diffusion to reduce its effective concentration to set the breakdown voltage of diode 17 to the desired level. This diffusion step reduces the effective doping concentration of epitaxial layer 31 within a depth less than about three micrometers.

An isolation region or sinker 12 is formed as a ring around ESD device 20 with a p-type conductivity and a depth of about twenty micrometers to electrically isolate ESD device 20 from other components. Sinker 12 is diffused through epitaxial layers 31-32 to provide an external electrical contact to base layer 30 at surface 35, which is facilitated by adding a doped region 36 using the processing steps used to form doped region 33. Hence, doped region 36 has a p-type conductivity to electrically couple sinker 12 through doped region 36 to an interconnect trace connected to lead 62.

A channel stopper 34 is heavily doped to have an n-type conductivity and a depth of about three micrometers. Channel stopper 34 surrounds doped region 33 and prevents surface 35 from inverting to form a channel that would result in a conduction path from doped region 33 to base layer 20. In addition, channel stopper 34 increases ESD robustness of the device by ensuring the dissipation of lateral current flow injected during ESD event to avoid current filaments forming at surface 35.

A dielectric material is disposed on surface 35 and patterned and etched to produce dielectric regions 45. In one embodiment, dielectric regions 45 comprise silicon dioxide thermally grown to a thickness of about five hundred angstroms followed by a layer about one micrometer thick of deposited silicon dioxide.

Capacitor 21 is formed as a trench capacitor by etching semiconductor substrate 11 to a depth of about seven micrometers to form a plurality of trenches 40 within sinker 12 as shown. In an alternative embodiment, trench 40 comprises several rows of individual trenches or a single serpentine trench that extends along surface 35 and intersects the view plane multiple times as needed to produce C₂₁=1.0 nanofarads of capacitance.

A dielectric material is formed to line inner surfaces of trench 40 to form a dielectric liner 38. In one embodiment, the dielectric material includes silicon nitride formed to a thickness of about four hundred angstroms.

A conductive material such as doped polysilicon is deposited and etched to form a conductive region 37 that fills trench 40 to function as a first electrode of capacitor 21 with sinker 12 functioning as a second electrode. Sinker 12 is coupled to lead 62 through shallow, heavily doped p-type contact region 36 that is formed with the processing steps used to form doped region 33. Capacitor 22 is formed in a similar fashion.

Clamp diode 27 is formed by the junction of base layer 30 and epitaxial layer 31 and isolated from other components by surrounding it with sinker 12 as shown. Hence, clamp diode 27 has a breakdown characteristic similar to that of diode 18 in ESD device 20.

A standard integrated circuit metal layer is deposited and etched to form bonding pads 60 and 61, along with interconnect traces. Inductor 74 is concurrently formed by patterning this standard integrated circuit metal layer. Other interconnect traces are represented schematically to simplify the figure.

Node 64 comprises a bonding structure shown as a metallic bump such as a solder bump or copper bump used for mounting filter 10 in a flip-chip fashion to a system circuit board (not shown). Alternatively, the bonding structure may comprise a wire bond or other suitable structure for providing external electrical and/or mechanical connections. The bonding structure has a parasitic inductance L₆₄ of between about 0.05 and 0.1 nanohenries which produces an impedance or inductive reactance X₆₄=2*Π*f_{c}*L₆₄ to input signal V_{IN}, where f_{c} is the RF carrier frequency of transmitter signal V_{XMIT}. For example, if L₆₄=0.1 nanohenries and f_{c}=6.0 gigahertz, X₆₄=2*Π*(6.0*10⁹)*(0.1*10⁻⁹) has a value of about four ohms.

Output signal V_{OUT} is provided at node 65 through a structure similar to that of node 64. The node 65 bonding structure has a parasitic inductance L₆₅ whose value is similar to the value of L₆₄.

FIG. 3A is a top view of a portion of filter 10 showing inductor 74 formed around bonding pad 60. In the embodiment of FIG. 3A, inductor 74 is formed as a single winding that circumscribes the perimeter of bonding pad 60 and is spaced about twenty micrometers away. Alternatively, inductor 74 may be formed as a planar spiral inductor having multiple windings. Inductor 74 typically has an inductance in a range between one and five nanohenries. Inductor 74 provides a smoothing function that flattens or integrates the voltage peaks of an ESD event, thereby improving the robustness of filter 10. In addition, inductor 74 improves signal filtering by compensating for high frequency signal feedthrough due to parasitic inductances L₆₄ and L₆₅ described above.

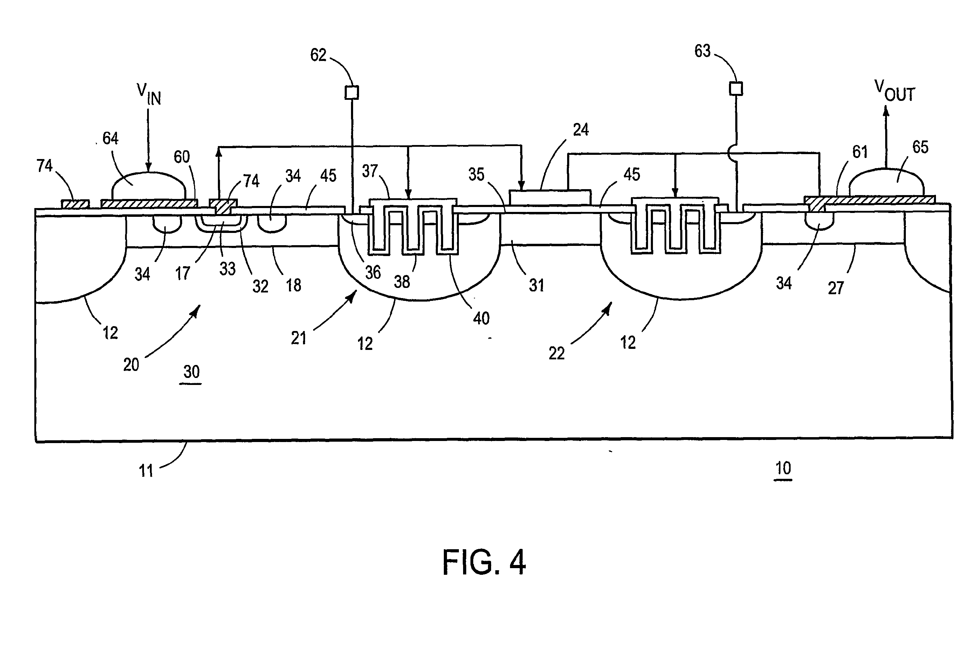

FIG. 4 is a cross-sectional view of filter 10 in an alternate embodiment. The previously described features have similar structures and operation, except that epitaxial layer 31 is grown to a thickness of about 5.5 micrometers. Layer 32 is formed as a masked region of p-type conductivity that surrounds doped region 33. In this embodiment, region 32 has the same conductivity type but is more lightly doped than doped region 33, which has the effect of shifting the portion of diode 17 which breaks down to the bottom surface of layer 32 rather than side surfaces. This adjustment ensures that diode 17 has a large effective breakdown area and low impedance to dissipate the energy generated by an ESD event, thereby providing a high degree of reliability.

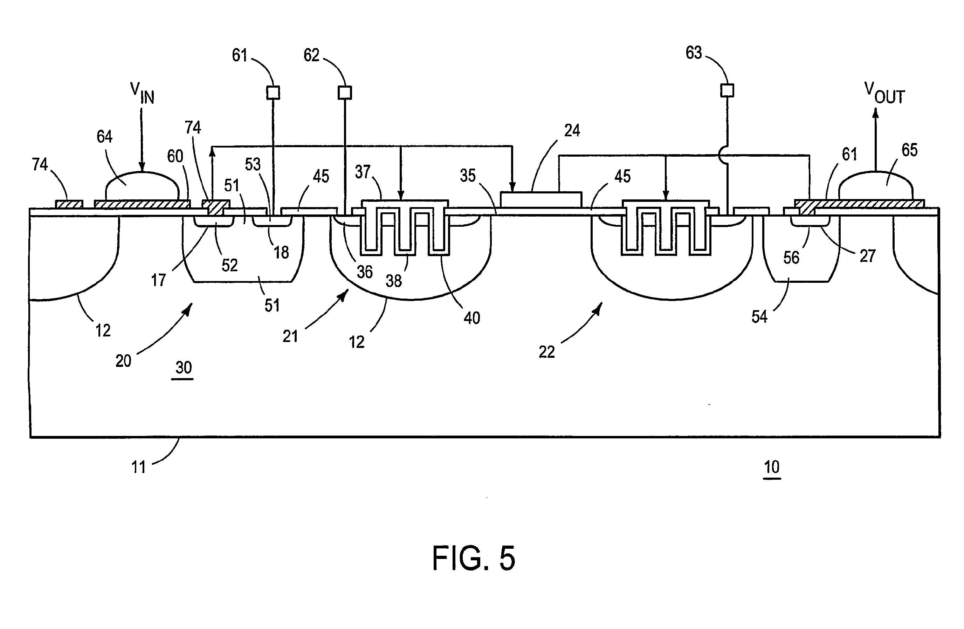

FIG. 5 is a cross sectional view of filter 10 in an example not forming part of the claimed invention in which base layer 30 is formed as a high resistivity material. In this embodiment, base layer 30 comprises lightly doped n-type monocrystalline silicon with an effective carrier concentration of 3*10¹² atoms/centimeter³ and a resistivity of about one thousand ohm-centimeters. Such a high resistivity improves the electrical isolation between adjacent components which reduces signal coupling through parasitic signal paths and improves filter performance.

P-type dopants are implanted through surface 35 and diffused into semiconductor substrate 11 to form well regions 51 and 54. In one embodiment, well regions 51 and 54 are formed to a depth of about fifteen micrometers. Well regions 51 and 54 typically are doped to a lower concentration than sinkers 12 but the same thermal cycle is used to diffuse well regions 51 and 54 and sinkers 12 into substrate 11. The lower concentration of well regions 51 and 54 results in their being shallower than sinkers 12.

N-type dopants are introduced into substrate 11 through openings in dielectric region 45 to form doped regions 52-53 within well region 51 and a doped region 56 within well region 54. Doped regions 52-53 form junctions with well region 51 that operate as back to back diodes 17-18, respectively, of ESD device 20. The doping concentrations of well region 51 and doped regions 52-53 are adjusted to provide a predefined breakdown voltage to meet the specified performance of ESD device 20. In one example, doped regions 52-53 are each formed with a rectangular shape to occupy an area of surface 35 which is about two hundred micrometers on a side. Note that because doped regions 52 and 53 are formed with the same processing steps the avalanche breakdown voltages and other performance parameters are symmetrical with respect to the polarity of the voltage on node 64.

Similarly, doped region 56 and well region 54 form a junction that comprises clamp diode 27.

In summary, the present invention provides an integrated filter circuit that achieves a specified frequency selectivity while utilizing integrated circuit technology to achieve a small physical size and a low manufacturing cost. A semiconductor substrate is formed with a trench that is lined with a dielectric layer. A conductive material is used to fill the trench to provide a capacitance that filters an input signal. Back to back diodes are formed in the substrate to avalanche when an electrostatic discharge voltage reaches a predetermined magnitude.

## Claims

1. An integrated filter for filtering an input signal comprising:
an input (64) to receive an input signal (V_{IN}) of the integrated filter;
a node (66);
a first capacitor (21) which is coupled between the node (66) and a ground reference node to provide a capacitance that modifies a frequency response of the input signal (V_{IN}) to produce a filtered signal;
an output (65) of the integrated filter which forms an output signal (V_{OUT}) of the integrated filter;
an inductor (74) which is coupled between the input (64) and the node (66);
a protection circuit that includes the inductor (74) coupled to back to back diodes (17, 18) to avalanche when a voltage on the node (66) reaches a predetermined magnitude, wherein a first diode (17) of the back to back diodes is coupled to the node (66) and the second diode (18) is coupled to the ground reference node;
a second capacitor (22) coupled between the output (65) and ground reference node;
a clamp diode (27) coupled in parallel with the second capacitor (22); and
a resistor (24) coupled between the node (66) and the output (65);
wherein the integrated filter further comprises a semiconductor substrate (11), the semiconductor substrate (11) including a base layer (30) of a first conductivity type and a doping concentration in a range between 10¹⁸ and 10²¹ atoms per cubic centimeter;
wherein the first capacitor (21) comprises a first trench formed in the semiconductor substrate (11), the trench being lined with a first dielectric layer (38) and a first portion of a conductive material (37) disposed in the first trench (40);
wherein the back to back diodes (17,18) are formed in the semiconductor substrate;
the second diode (18) being formed from a first portion of a first doped region (31,32) of a second conductivity type that forms a first junction with the base layer (30), and the first diode (17) being formed from a second doped region (33) having the first conductivity type for forming a second junction with the first portion of the first doped region (31,32), wherein the second doped region (33) is coupled to the node (66);
wherein the resistor (24) is formed as a thin film resistor;
wherein the inductor (74) is formed as a planar device on a surface of the semiconductor substrate (11);
wherein the clamp diode (27) is formed by the junction of the base layer (30) and a second portion of the first doped region (31,32), the clamp diode being isolated from other components by a first conductivity type sinker surrounding the clamp diode (27); and
wherein the second capacitor (22) comprises a second trench formed in the semiconductor substrate, the second trench being lined with a second dielectric layer and a second portion of conductive material disposed in the second trench.

2. The integrated filter of claim 1, wherein the first doped region (31,32) comprises an epitaxial layer grown on the base layer (30) ; and wherein the second doped region (33) is diffused from a surface of the epitaxial layer.

3. The integrated filter of claim 2, wherein the second doped region includes:
a first portion having a first surface concentration and diffused to a first depth; and
a second portion having a second surface concentration less than the first surface concentration and diffused to a second depth greater than the first depth.

4. The integrated filter of claim 2, wherein impurities of the first conductivity type are diffused through a surface of the epitaxial layer to reduce an effective doping concentration of the epitaxial layer within a depth less than three micrometers.

5. The integrated filter of claim 1, wherein the trenches are formed in respective first well regions of the semiconductor substrate, the first well regions having the first conductivity type.

6. A wireless communications device, comprising:
a power stage that receives a modulated signal and transmits an output signal of the wireless communications device;
a modulator that modulates a radio frequency carrier signal with an audio signal to produce the modulated signal;
a microphone for converting voice information to the audio signal, where the microphone receives a portion of the output signal; and
a the integrated filter formed on the semiconductor substrate and interposed between the microphone and the power stage for attenuating radio frequency components of the output signal, the integrated filter being as claimed in any of claims 1 to 5.

## Patentansprüche

1. Integriertes Filter zum Filtern eines Eingangssignals, welches Folgendes enthält:
einen Eingang (64) zum Empfang eines Eingangssignals (V_{IN}) des integrierten Filters,
einen Knoten (66),
einen ersten Kondensator (21), der zwischen dem Knoten (66) und einem Basisreferenzknoten geschaltet ist, um eine Kapazität zur Verfügung zu stellen, die die Frequenzantwort des Eingangssignals (V_{IN}) modifiziert, um ein gefiltertes Signal zu erzeugen,
einen Ausgang (65) des integrierten Filters, der ein Ausgangssignal (V_{OUT}) des integrierten Filters bildet,
einen Induktor (74), der zwischen dem Eingang (64) und dem Knoten (66) geschaltet ist,
eine Schutzschaltung, die den Induktor (74) enthält, die an back to back Dioden (17, 18) geschaltet ist, um lawinenartig zu wirken, wenn eine Spannung an dem Knoten (66) eine bestimmte Größe erreicht, wobei eine erste Diode (17) der back to back Dioden mit dem Knoten (66) und die zweite Diode (18) mit dem Basisreferenzknoten gekoppelt ist,
einen zweiten Kondensator (22), der zwischen dem Ausgang (65) und dem Basisreferenzknoten geschaltet ist,
eine Klemmdiode (27), die parallel zum zweiten Kondensator (22) gekoppelt ist, und
einen Widerstand (24), der zwischen dem Knoten (66) und dem Ausgang (65) geschaltet ist,
wobei das integrierte Filter ferner ein Halbleitersubstrat (11) enthält, wobei das Halbleitersubstrat (11) eine Basisschicht (30) eines ersten Leitfähigkeitstyps und einer Dotierungskonzentration in einem Bereich zwischen 10¹⁸ und 10²¹ Atomen pro Kubikzentimeter enthält,
wobei der erste Kondensator (21) einen ersten Graben in dem Halbleitersubstrat (11) enthält, und der Graben mit einer ersten dielektrischen Schicht (38) ausgebildet ist und ein erster Teil eines leitfähigen Materials (37) in dem ersten Graben (40) angeordnet ist,
wobei die back to back Dioden (17, 18) in dem Halbleitersubstrat ausgebildet sind,
wobei die zweite Diode (18) aus einem ersten Teil einer ersten dotierten Region (31, 32) eines zweiten Leitfähigkeitstyps geformt ist, die einen ersten Übergang mit der Basisschicht (30) bildet und die erste Diode (17) aus einer zweiten dotierten Region (33) gebildet ist, die den ersten Leitfähigkeitstyp aufweist, um einen zweiten Übergang mit dem ersten Teil der ersten dotierten Region (31, 32) zu bilden, wobei die zweite dotierte Region (33) mit dem Knoten (66) gekoppelt ist,
wobei der Widerstand (24) als Dünnfilmtransistor ausgebildet ist,
wobei der Induktor (74) als ebene Einrichtung auf der Oberfläche des Halbleitersubstrats (11) ausgebildet ist,
wobei die Klemmdiode (27) durch den Übergang der Basisschicht (30) und
einen zweiten Bereich der ersten dotierten Region (31, 32) gebildet ist, wobei die Klemmdiode von den anderen Komponenten durch eine erste Leitfähigkeitstyp-Senke um die Klemmdiode (27) isoliert ist, und
wobei der zweite Kondensator (22) einen zweiten Graben auf dem Halbleitersubstrat bildet, wobei der zweite Graben mit einer zweiten dielektrischen Schicht ausgekleidet ist und ein zweiter Bereich des Leitfähigkeitsmaterials in dem zweiten Graben angeordnet ist.

2. Integriertes Filter nach Anspruch 1, wobei die erste dotierte Region (31, 32) eine Epitaxialschicht aufweist, die auf der Basisschicht (30) gewachsen ist, und wobei die zweiten dotierte Region (33) von der Oberfläche der Exptaxialchicht diffundiert ist.

3. Integriertes Filter nach Anspruch 2, wobei die zweite dotierte Region Folgendes enthält:
einen ersten Teil, der eine erste Oberflächenkonzentration enthält und zu einer ersten Tiefe diffundiert ist, und
ein zweiter Bereich, der eine zweite Oberflächenkonzentration hat, die kleiner als die erste Oberflächenkonzentration ist und zu einer zweiten Tiefe größer als die erste Tiefe diffundiert ist.

4. Integriertes Filter nach Anspruch 2, bei dem Unreinheiten des ersten Leitfähigkeitstyps durch eine Oberfläche der Epitaxialschicht diffundiert sind, um eine effektive Dotierungskonzentration der Epitaxialschicht innerhalb einer Tiefe auf unter 3 Mikrometer zu reduzieren.

5. Integriertes Filter nach Anspruch 1, wobei Gräben jeweils in den ersten Brunnenbereichen des Halbleitersubstrats ausgebildet sind, wobei die ersten Brunnenbereiche einen Leitfähigkeitstyp aufweisen.

6. Drahtloses Kommunikationsgerät, welches Folgendes enthält:
eine Leistungsstufe, die ein moduliertes Signal empfängt und ein Ausgangssignal des drahtlosen Kommunikationsgerätes aussendet,
einen Modulator, der ein Funkfrequenzträgersignal mit einem Audiosignal moduliert, um das modulierte Signal zu erzeugen,
ein Mikrofon zur Umwandlung von Sprachinformation in das Audiosignal, wobei das Mikrofon einen Teil des Ausgangssignals erhält, und
ein integriertes Filter, das auf dem Halbleitersubstrat ausgebildet ist und
zwischen dem Mikrofon und einer Leistungsstufe geschaltet ist, um die Radiofrequenzkomponenten des Ausgangssignals zu dämpfen, wobei das integrierte Filter nach einem der Ansprüche 1 - 5 ausgebildet ist.

## Revendications

1. Filtre intégré destiné à filtrer un signal d'entrée comprenant:
une entrée (64) destinée à recevoir un signal d'entrée (V_{IN}) du filtre intégré;
un noeud (66) ;
un premier condensateur (21) qui est couplé entre le noeud (66) et un noeud de référence à la masse destiné à fournir une capacité qui modifie une réponse en fréquence du signal d'entrée (V_{IN}) de façon à produire un signal filtré;
une sortie (65) du filtre intégré qui forme un signal de sortie (V_{OUT}) du filtre intégré;
un inducteur (74) qui est couplé entre l'entrée (64) et le noeud (66);
un circuit de protection qui comprend l'inducteur (74) couplé à des diodes montées tête-bêche (17, 18) de façon à claquer en avalanche quand une tension présente sur le noeud (66) atteint une grandeur prédéterminée, dans lequel une première diode (17) des diodes montées tête-bêche est couplée au noeud (66) et la seconde diode (18) est couplée au noeud de référence à la masse;
un second condensateur (22) couplé entre la sortie (65) et le noeud de référence à la masse;
une diode de fixation de niveau (27) couplée en parallèle avec le second condensateur (22); et
un résisteur (24) couplé entre le noeud (66) et la sortie (65);
dans lequel le filtre intégré comprend en outre un substrat de semi-conducteur (11), le substrat de semi-conducteur (11) comprenant une couche de base (30) qui présente un premier type de conductivité et une concentration de dopage qui se situe dans une plage comprise entre 10¹⁸ et 10²¹ atomes par centimètre cube;
dans lequel le premier condensateur (21) comprend une première tranchée formée dans le substrat de semi-conducteur (11), la tranchée étant recouverte d'une première couche diélectrique (38) et d'une première partie d'un matériau conducteur (37) disposée dans la première tranchée (40);
dans lequel les diodes montées tête-bêche (17, 18) sont formées dans le substrat de semi-conducteur;
la seconde diode (18) étant formée à partir d'une première partie d'une première région dopée (31, 32) qui présente un second type de conductivité qui forme une première jonction avec la couche de base (30), et la première diode (17) étant formée à partir d'une seconde région dopée (33) qui présente le premier type de conductivité de façon à former une seconde jonction avec la première partie de la première région dopée (31, 32), dans lequel la seconde région dopée (33) est couplée au noeud (66);
dans lequel le résisteur (24) est formé sous la forme d'un résisteur à couches minces ;
dans lequel l'inducteur (74) est formé sous la forme d'un dispositif plan sur une surface du substrat de semi-conducteur (11);
dans lequel la diode de fixation de niveau (27) est formée par la jonction de la couche de base (30) et une seconde partie de la première région dopée (31, 32), la diode de fixation de niveau étant isolée des autres composants par une fosse qui présente un premier type de conductivité et qui entoure la diode de fixation de niveau (27); et
dans lequel le second condensateur (22) comprend une seconde tranchée formée dans le substrat de semi-conducteur, la seconde tranchée étant recouverte d'une seconde couche diélectrique et d'une seconde partie de matériau conducteur disposées dans la seconde tranchée.

2. Filtre intégré selon la revendication 1, dans lequel la première région dopée (31, 32) comprend une couche épitaxiale développée sur la couche de base (30) ; et dans lequel la seconde région dopée (33) est diffusée à partir d'une surface de la couche épitaxiale.

3. Filtre intégré selon la revendication 2, dans lequel la seconde région dopée comprend :
une première partie qui présente une première concentration de surface et qui est diffusée à une première profondeur; et
une seconde partie qui présente une seconde concentration de surface qui est inférieure à la première concentration de surface et qui est diffusée à une seconde profondeur plus profonde que la première profondeur.

4. Filtre intégré selon la revendication 2, dans lequel des impuretés du premier type de conductivité sont diffusées à travers une surface de la couche épitaxiale de façon à réduire une concentration de dopage efficace de la couche épitaxiale à une profondeur inférieure à trois micromètres.

5. Filtre intégré selon la revendication 1, dans lequel les tranchées sont formées dans des premières régions de puits respectives du substrat de semi-conducteur, les premières régions de puits présentant le premier type de conductivité.

6. Dispositif de communication sans fil, comprenant:
un étage de puissance qui reçoit un signal modulé et qui transmet un signal de sortie du dispositif de communication sans fil;
un modulateur qui module un signal de porteuse radioélectrique avec un signal audio de façon à produire le signal modulé;
un microphone destiné à convertir des informations de voix en un signal audio, où le microphone reçoit une partie du signal de sortie; et
un filtre intégré formé sur le substrat de semi-conducteur et interposé entre le microphone et l'étage de puissance de façon à atténuer les composantes radioélectriques du signal de sortie, le filtre intégré étant selon l'une quelconque des revendications 1 à 5.
